(19) Europäisches Patentamt
European Patent Office
Office européen des brevets

(11) **EP 3 870 986 B1**

(12) **FASCICULE DE BREVET EUROPEEN**

(45) Date de publication et mention de la délivrance du brevet:
**08.06.2022 Bulletin 2022/23**

(21) Numéro de dépôt: **19790665.4**

(22) Date de dépôt: **18.09.2019**

(51) Classification Internationale des Brevets (IPC):
**G01R 31/392** *(2019.01)*

(52) Classification Coopérative des Brevets (CPC):
**G01R 31/392;** G01R 31/367; Y02T 10/70

(86) Numéro de dépôt international:
**PCT/FR2019/052172**

(87) Numéro de publication internationale:
**WO 2020/084212 (30.04.2020 Gazette 2020/18)**

(54) **PROCEDE DE DETERMINATION DE L'ETAT DE VIEILLISSEMENT D'UNE BATTERIE ELECTROCHIMIQUE**

VERFAHREN ZUR BESTIMMUNG DES ALTERUNGSZUSTANDES EINER ELEKTROCHEMISCHEN BATTERIE

METHOD FOR DETERMINING THE STATE OF AGEING OF AN ELECTROCHEMICAL BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.10.2018 FR 1859766**

(43) Date de publication de la demande:
**01.09.2021 Bulletin 2021/35**

(73) Titulaire: **PSA Automobiles SA**
**78300 Poissy (FR)**

(72) Inventeur: **BAGHDADI, Issam**
**78600 Le Mesnil-le-Roi (FR)**

(56) Documents cités:
**WO-A1-2017/050944**

**Description**

Le domaine de l'invention concerne un procédé de détermination d'un paramètre d'état de vieillissement d'une batterie électrochimique, ainsi qu'une unité de commande comportant des moyens de mettre en œuvre ledit procédé.

Dans l'industrie automobile, les véhicules hybrides et véhicules électriques embarquent des systèmes de batterie de puissance munis d'accumulateurs électrochimiques (appelés également cellules) destinés à alimenter les machines motrices électriques du véhicule. Ces systèmes ont aujourd'hui un rôle essentiel pour améliorer les performances énergétiques du véhicule en termes de réduction de la consommation de carburant, d'autonomie de roulage électrique et de puissance de motorisation. Par ailleurs, de nombreuses fonctions de motorisation du groupe motopropulseur dépendent des valeurs des indicateurs d'états du système de batterie, tel le niveau d'état de charge et l'état de vieillissement du système de batteries désignés respectivement par les acronymes anglais SOC pour « State of Charge » et SOH pour « State of Health ». Par exemple, les décisions de démarrage d'un moteur thermique, le choix entre un mode de roulage hybride ou tout électrique, ou encore des fonctions de navigation de planification de parcours reposent bien souvent sur le niveau d'état de charge du système de batterie. La précision et la mise à jour des indicateurs d'état sont donc cruciales pour le fonctionnement et l'agrément de conduite du véhicule. L'unité de commande du système de batterie, couramment appelée par l'acronyme BMS pour « Battery management System » en anglais, a pour tâche d'estimer en temps réels ces indicateurs d'état.

Parmi ces indicateurs, l'état de vieillissement est indispensable pour la gestion du système de batterie. En effet, l'état de vieillissement permet de quantifier la quantité d'énergie maximale que peut délivrer la batterie après une charge complète. On connait de l'état de la technique le document WO2015049300A1 dans lequel la caractéristique de la chute de courant en recharge à tension constante évolue linéairement avec l'état de vieillissement de la batterie. Ce courant décroit exponentiellement avec le temps. De plus, le document WO2017050944A1 décrit un procédé exploitant la linéarité de la relation entre la tension à circuit ouvert et l'état de vieillissement. Ces solutions présentent néanmoins les désavantages suivants.

Comme cela est bien connu, la courbe de tension à circuit ouvert, appelée également par l'acronyme anglais OCV « Open Circuit Voltage », est d'une grande importance car nombre de caractéristiques électriques sont déduites par calcul à partir de sa valeur. Or, la tension OCV doit être mesurée à l'équilibre thermodynamique d'un accumulateur électrique et cet équilibre n'est atteint qu'après une durée assez longue, souvent supérieure à une heure. Les usages automobiles réduisent les opportunités d'occurrence d'une telle durée et empêchent une estimation et mise à jour en temps réel durant le roulage. De plus, les futures applications dites « intelligentes » des systèmes de batterie conçus pour intervenir dans la gestion des réseaux électriques domestiques réduiront les occurrences des phases de relaxation.

Par ailleurs, la méthode proposée dans WO2015049300A1 requière d'opérer une recharge complète afin de déterminer l'indicateur nécessaire au diagnostic de l'état de vieillissement de la batterie. Cette méthode n'est donc pas applicable dans le cadre de recharges partielles. De même, pour WO2017050944A1, la méthode n'est applicable que si la batterie est complètement chargée ou complètement déchargée.

Il existe donc un besoin de palier les problèmes précités. Un objectif principal est d'améliorer les méthodes de détermination de l'état de vieillissement d'un système de batterie. En particulier, l'invention a pour objectif de réduire le temps de calcul et de permettre la détermination de l'état de vieillissement quel que soit le niveau d'état de charge de la batterie.

Plus précisément, l'invention concerne un procédé de détermination d'un premier paramètre représentatif de l'état de vieillissement d'une batterie électrochimique d'un système de batterie, le procédé étant exécuté par une unité de commande du système de batterie et comportant les étapes successives suivantes :

- la mesure en continu d'un signal de tension, Uacc(t), aux bornes de la batterie en relaxation en fonction du temps écoulé,
- l'estimation du premier paramètre de d'état de vieillissement dépendant dudit signal de tension mesuré.

Le procédé est remarquable en ce qu'il comporte en outre :

- le calcul en continu durant la relaxation de la batterie d'un signal logarithmique de la tension dépendant dudit signal de tension Uacc(t) en fonction de la valeur sous forme logarithmique du temps écoulé à partir du premier instant (t0),
- une étape de calcul d'une fonction de modélisation du signal logarithmique en fonction des valeurs du signal logarithmique,
- le calcul d'un deuxième paramètre représentatif de la vitesse d'évolution de la fonction de modélisation du signal logarithmique lors de la relaxation, ladite vitesse d'évolution étant représentative de la vitesse d'autocatalyse de la batterie lors d'une phase de relaxation,
- l'estimation du premier paramètre d'état de vieillissement en fonction du deuxième paramètre et d'une cartographie prédéterminée, ladite cartographie étant enregistrée en mémoire de l'unité de commande et fournissant une valeur prédéterminée du premier paramètre d'état de vieillissement en fonction de la valeur du deuxième paramètre.

Selon une variante, le calcul de la fonction de modélisation consiste à ajuster les paramètres de la fonction de modélisation et le deuxième paramètre est calculé en fonction des paramètres ajustés de la fonction de modélisation.

Selon une variante, la fonction de modélisation est une fonction g parmi l'une quelconque des relations suivantes :

[Math 1]

$$g: x \rightarrow a * \tanh(b * x),$$

ou

[Math 2]

$$g: x \rightarrow a * \mathrm{arcsinh}(b * x),$$

ou

[Math 3]

$$g: x \rightarrow a * sigmf(b * x) - 0{,}5,$$

Où a et b sont des paramètres ajustés et le deuxième paramètre Vac est calculé selon la relation suivante :

[Math 4]

$$Vac = a * b$$

Selon une variante du procédé, il comporte en outre une étape de détection d'un point d'inflexion du signal logarithmique de la tension et la fonction de modélisation logarithmique est calculée symétriquement par rapport audit point d'inflexion en fonction des valeurs mesurées du signal logarithmique antérieures à l'instant dudit point d'inflexion.

Plus précisément, la cartographie prédéterminée a été élaborée lors d'une phase de vieillissement d'une batterie électrochimique.

Plus précisément, la cartographie prédéterminée fournit une pluralité de valeurs d'état de vieillissement prédéterminées en fonction d'une pluralité de valeurs prédéterminées du deuxième paramètre.

L'invention prévoit également une unité de commande d'un système de batterie comportant une batterie électrochimique, comportant en outre une mémoire dans laquelle est enregistrée une cartographie prédéterminée apte à fournir des valeurs prédéterminées d'un premier paramètre d'état de vieillissement de la batterie en fonction de valeurs prédéterminées d'un deuxième paramètre représentatif de la vitesse d'autocatalyse de la batterie lors d'une phase de relaxation et des moyens de mettre en œuvre le procédé selon l'un quelconque des modes de réalisation précédents.

Il est également envisagé selon l'invention un véhicule automobile comprenant un système de batterie comportant ladite unité de commande.

L'invention concerne également un produit programme-ordinateur comprenant des instructions qui, lorsque le programme est exécuté par une unité de commande du système de batterie, conduisent celui-ci à mettre en œuvre l'un quelconque des modes de réalisation du procédé de détermination de l'état de vieillissement conformément à l'invention.

Le procédé selon l'invention requière peu de ressources de calcul facilitant ainsi l'intégration pour des applications embarquées, tels les systèmes de batterie de véhicule et dispositifs portable. Par ailleurs, le résultat du procédé n'est pas affecté par le niveau de l'état de charge de la batterie. Cette propriété augmente les occurrences d'exécution du procédé et améliore la gestion des indicateurs d'état du système de batterie.

D'autres caractéristiques et avantages de la présente invention apparaitront plus clairement à la lecture de la description détaillée qui suit comprenant des modes de réalisation de l'invention données à titre d'exemples nullement limitatifs et illustrés par les dessins annexés, dans lesquels :

[Fig. 1] représente un système de batterie comportant une batterie électrochimique et une unité de commande configurée pour mettre en oeuvre le procédé selon l'invention.

[Fig. 2] est un organigramme représentant un algorithme du procédé selon l'invention permettant de caractériser la vitesse d'autocatalyse des réactifs de la batterie en relaxation et le paramètre de vieillissement.

[Fig. 3] est un graphique représentant l'évolution de la courbe de tension d'une batterie en relaxation et l'évolution d'un signal logarithmique permettant de caractériser la vitesse d'autocatalyse lors de la relaxation de la batterie.

[Fig. 4] est un graphique représentant une cartographie prédéterminée enregistrée en mémoire de l'unité de commande permettant de déterminer l'état de vieillissement à partir de paramètres caractéristiques d'une modélisation du signal logarithmique de la tension.

L'invention concerne un procédé de détermination du paramètre de vieillissement d'une batterie électrochimique d'un système de batterie, souvent désigné également l'expression module de batterie ou par le terme anglais « pack ». L'invention exploite la propriété que la vitesse d'évolution du signal de tension de la batterie en relaxation, lorsque ce signal est exprimé sous la forme d'un signal logarithmique, est proportionnel à l'évolution de la vitesse volumique de la transformation de phase (ou vitesse d'autocatalyse) des réactifs lors de la relaxation. En effet, les concentrations volumiques des réactifs évoluent comme une courbe en forme de S ou forme de sigmoïde par rapport au temps. Le procédé a pour objectif de modéliser par ajustement paramétrique cette évolution temporelle à partir de la mesure du signal de tension et du signal logarithmique associé. Finalement, à partir d'une estimation d'un paramètre représentatif de la vitesse d'autocatalyse et d'une cartographie prédéterminée mettant en relation ce paramètre et l'état de vieillissement, il est possible grâce au procédé d'estimer l'état de vieillissement lors de l'usage d'une batterie. Cette relation est déterminée et mémorisée sous forme de cartographie préalablement lors d'une opération de vieillissement pour la mise en œuvre du procédé lors de l'usage de la batterie.

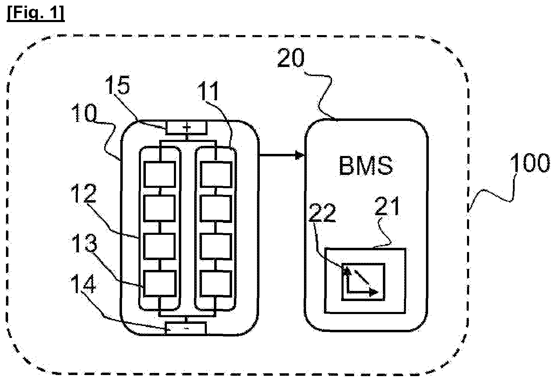

La figure 1 illustre schématiquement un système de batterie 100 destiné à équiper un véhicule automobile électrique comprenant une pluralité d'accumulateurs électrochimiques. Le système de batterie 100 comporte un module d'accumulateurs électrochimiques 10 et une unité de commande 20 pour la gestion du module 10. Typiquement, dans le cas d'une application de groupe motopropulseur automobile hybride électrique ou entièrement électrique, un système de batterie des machines motrices peut être équipé d'une pluralité de modules permettant le stockage et la restitution d'énergie électrique. Le module 10 peut être adressé individuellement par le système de batterie 100. Le module 10 comporte deux bornes de connexion 15, 14 pouvant fournir une tension électrique et un courant électrique déterminés en fonction du nombre de cellules électriques 13 assemblées en série et/ou en parallèle. Par exemple, le module 10 de cellules unitaires 13 comporte deux rangées 11, 12 ou plus montées en parallèle, chaque rangée étant constituée de cellules électriques unitaires 13 connectées en série.

Le système de batterie électrochimique 100 est de technologie de type Lithium, Li-ion, ou autres. Il est bien entendu que le système de batterie 100 et le procédé selon l'invention s'applique à d'autres applications, plus généralement à tout dispositif électrique ou électronique requérant une alimentation électrique constituée d'accumulateurs électrochimiques. Dispositifs portables, ordinateurs, installation d'alimentation électriques, satellites et bancs de test et de calibration sont des exemples d'une liste non exhaustive pour lesquels l'invention peut s'appliquer.

Le procédé est exécutable pour déterminer le paramètre de vieillissement de chacun des modules de batterie adressable individuellement d'un système de batterie via des bornes de connexion électrique dudit module, ou pour déterminer le paramètre de vieillissement d'un système dans son ensemble, ou bien encore d'une cellule unitaire lorsque celle-ci est adressable individuellement.

L'unité de commande 20 est un calculateur électronique à circuits intégrés muni d'un processeur et de mémoires électroniques pour exécuter le procédé de détermination du paramètre de vieillissement d'un module de batterie électrochimique. L'unité de commande 20 comporte des moyens de mesure de la tension et du courant du module 10 (capteurs de tension et de courant), des moyens de détection d'une phase de relaxation du module de batterie, plus précisément la détection d'un courant nul aux bornes du module, et des moyens de calcul pour opérer les étapes de calcul du procédé qui seront décrites ci-après. L'unité de commande comporte des moyens pour enregistrer les indicateurs d'état d'un module, tels l'indicateur de tension à circuit ouvert OCV, l'indicateur d'état de vieillissement SOH et l'indicateur d'état de charge SOC par exemple à des fins de gestion du système de batterie au cours de la vie d'utilisation du véhicule. On ajoutera que selon l'application l'unité de commande est un système de gestion de la batterie embarqué (par exemple BMS d'un véhicule automobile) ou tout type de dispositif de contrôle de la batterie (ordinateur, application de gestion distante, ou ordinateur de banc de test).

Conformément à l'invention, l'unité de commande 20 comporte un module de calcul 21 de l'état de vieillissement du module de batterie 10. A cet effet, le module de calcul 21 comporte une mémoire sur laquelle est enregistrée une cartographie prédéterminée 22 permettant de fournir une valeur prédéterminée du paramètre d'état de vieillissement de la batterie en fonction d'un paramètre représentatif de la vitesse d'autocatalyse se déroulant lors de la réaction de relaxation de la batterie. Ainsi, en fonction d'une valeur du paramètre représentatif de vitesse d'autocatalyse qui est calculée lors du procédé et qui est fournie en donnée d'entrée de la cartographie, l'unité de commande lit une valeur du paramètre d'état de vieillissement.

Plus précisément, le paramètre représentatif de la vitesse d'autocatalyse est calculé à partir des paramètres caractérisant une fonction de modélisation de la courbe d'évolution de la tension de la batterie lors d'une phase de relaxation. La cartographie prédéterminée 22 a été élaborée préalablement lors d'une opération de vieillissement de la batterie. Lors de cette opération de vieillissement, pour une pluralité d'états de vieillissement connus, des étapes de calcul du paramètre représentatif de la vitesse d'autocatalyse sont exécutées. Ces étapes de calcul seront décrites plus précisément dans la suite lors de la description qui suit du procédé. La cartographie est configurée pour des états de vieillissement compris par exemple entre 30% et 100% de l'état de charge nominal.

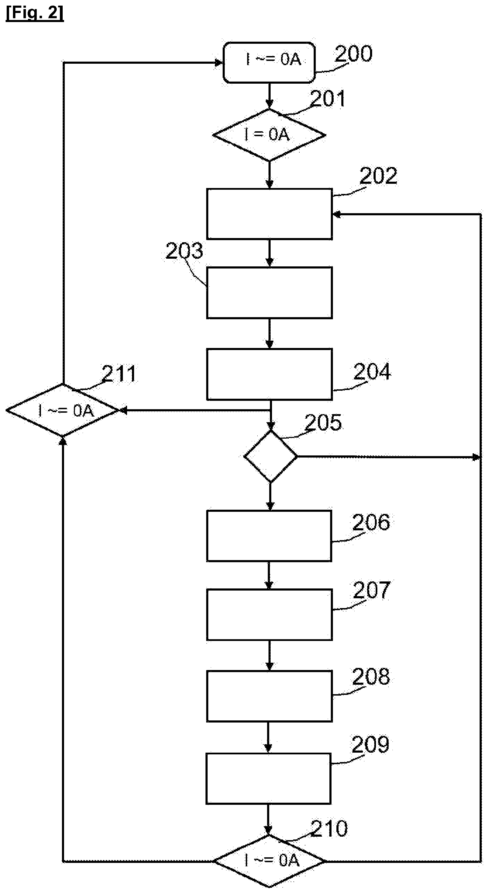

Le procédé de détermination de l'état de vieillissement d'une batterie est décrit maintenant en figure 2. A une première étape 200, l'unité de commande de l'accumulateur pilote une opération de recharge ou décharge électrique. Le courant est non nul aux bornes de l'accumulateur. Tant que le courant est non nul, le procédé reste à l'étape 200.

A l'étape 201, lorsqu'un courant nul aux bornes de l'accumulateur est détecté, l'unité de commande pilote une étape 202 de mesure en continu au moyen d'un capteur de tension à partir de l'instant t0 d'un signal de tension Uacc(t) pour des instants supérieurs à t0. Les valeurs du signal de tension Uacc(t) sont enregistrées en mémoire de l'unité de commande.

Ensuite, à une étape 203, l'unité de commande calcule en continu durant la relaxation de l'accumulateur un signal logarithmique SF de la tension dépendant dudit signal de tension Uacc(t) en fonction de la valeur sous forme logarithmique du temps écoulé à partir de l'instant t0.

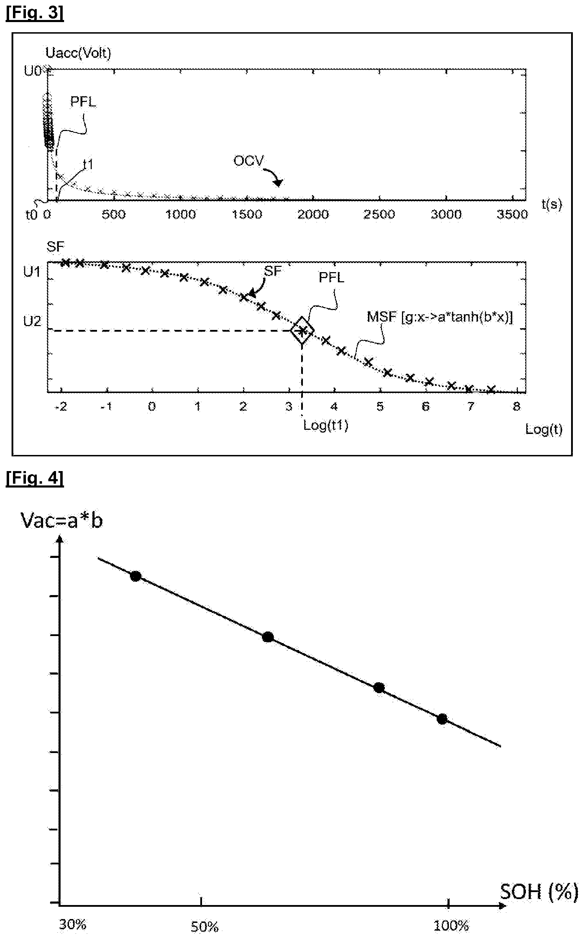

En figure 3, les valeurs du signal de tension Uacc(t) sont représentées sur la partie supérieure du graphique. Le graphique représente le signal de tension Uacc en unité de Volts mesuré aux bornes de l'accumulateur électrochimique lors d'une phase de relaxation en fonction du temps écoulé t, en unité de secondes, à partir d'un instant t0 du début de la phase de relaxation à la suite d'une opération de recharge de l'accumulateur ou une opération de décharge de l'accumulateur. A titre d'exemple illustratif, les valeurs de tension en cours de mesure sont représentées par des cercles, ici jusqu'à la détection d'un point d'inflexion à un instant t1. Les points indiqués en forme de croix représentent l'évolution attendue de la courbe de relaxation de la tension Uacc. U0 est la valeur de la tension Uacc au début de la phase de relaxation. Puis, après une durée de relaxation supérieure à environ 1000s, l'accumulateur électrochimique atteint l'équilibre thermodynamique à partir duquel la tension Uacc tend à se stabiliser à la valeur de tension à circuit ouvert OCV.

Par ailleurs, les valeurs du signal logarithmique SF sont représentées schématiquement sur la partie inférieure du graphique par des croix. Le signal logarithmique SF se caractérise par la forme d'une courbe en forme de S du fait des asymptotes à l'infini et de la symétrie par rapport à un point d'inflexion PFL pouvant être détecté à un instant t1. Le signal logarithmique SF caractérise la vitesse d'évolution de la transition de phase de la réaction électrochimique durant la relaxation de l'accumulateur électrochimique. Le signal SF permet ainsi de déterminer une vitesse d'autocatalyse qui est dépendante de l'état de vieillissement de la batterie.

Par ailleurs, l'étape de mesure 202 est réalisée jusqu'à l'atteinte de l'équilibre thermodynamique, tant que le courant aux bornes de l'accumulateur électrochimique est nul, ou jusqu'à la détection du point d'inflexion. Cette dernière variante permet de réduire le temps de calcul pour déterminer le signal logarithmique SF en exploitant la symétrie du signal logarithmique par rapport au point d'inflexion.

Plus précisément, au moins trois variantes du signal logarithmique SF sont calculables par l'unité de commande. Selon une première représentation f1 du signal de tension Uacc(t), le signal logarithmique SF représente le signal de tension Uacc(t) en fonction de la valeur du temps t sous forme logarithmique, où

[Math 5]

$$f1 : \log(t) \rightarrow Uacc(t)$$

Selon une autre variante, le signal logarithmique SF est une deuxième représentation f2 dudit signal de tension Uacc(t) sous une première forme logarithmique en fonction de la valeur du temps t sous forme logarithmique, où

[Math 6]

$$f2 : \log(t) \rightarrow \log(Uacc(t))$$

Ou encore, selon une autre variante, le signal logarithmique SF est une troisième représentation f3 dudit signal de tension Uacc(t) sous une deuxième forme logarithmique en fonction de la valeur du temps t sous forme logarithmique,

où

[Math 7]

$$f3 : \log(t) \to \log\big(\log\big(Uacc(t)\big)\big)$$

La fonction f3 est préférentiellement choisie lors de l'étape de calcul 203 du fait que le signal logarithmique SF du signal de tension est proportionnel au volume du réactif en cours de transformation de phase lors de la relaxation.

De plus, pour vérifier la présence d'un point d'inflexion sur la courbe du signal logarithmique SF, l'unité de commande calcule à l'étape 203 le signal de dérivée seconde du signal logarithmique SF. Il est bien entendu que d'autres variantes calculatoires de détection d'un point d'inflexion sont envisageables.

Ensuite, à une étape 204 du procédé, l'unité de commande enregistre dans une mémoire les valeurs du signal de tension Uacc(t) mesurées, les valeurs du signal logarithmique SF du signal de tension et les valeurs du signal de dérivée seconde le cas échéant.

A une étape 205, l'unité de commande vérifie en continu si le signal logarithmique SF présente un point d'inflexion. La détection est opérée en vérifiant le signe du signal de dérivée seconde. En cas de changement de signe, l'unité de commande détecte un point d'inflexion. Tant qu'aucun point d'inflexion est détecté, l'unité de commande opère en continu les étapes successives 202, 203, 204. De plus, lorsque l'unité de commande détecte à l'étape 211 un courant non nul, le procédé se termine et retourne à l'étape 200.

En référence à la figure 3, à l'instant t1, l'unité de commande détecte un point d'inflexion PFL. L'unité de commande enregistre en mémoire à l'étape 206 les valeurs du signal de tension Uacc et du signal logarithmique SF pour le point d'inflexion détecté.

Ensuite à une étape 207, le procédé comporte une étape de calcul d'une fonction de modélisation MSF du signal logarithmique SF en fonction des valeurs du signal logarithmique SF. La fonction de modélisation est représentée en figure 3 par le trait pointillé.

L'étape de calcul 207 consiste à ajuster les paramètres de la fonction de modélisation en forme de S à partir au moins des valeurs du signal logarithmique SF, par exemple une fonction de modélisation désignée g, de type sigmoïde, tangente hyperbolique ou arcsinus hyperbolique. En effet, lors de la relaxation, la réaction principale est gouvernée par la transformation des phases dans la matière active, réaction dite de germination autocatalytique, caractérisée par une vitesse sigmoïdale. La sigmoïde est équivalente à une fonction de tangente hyperbolique que l'unité de commande a pour objectif de modéliser pour identifier la vitesse sigmoïdale de la réaction autocatalytique.

L'unité de commande applique une méthode d'ajustement par optimisation paramétrique en diminuant l'erreur quadratique entre le signal logarithmique mesuré SF et la fonction de modélisation g. A titre d'exemples non limitatifs, la méthode d'ajustement exploite les algorithmes d'optimisation paramétrique connus de l'homme du métier, tels la méthode simplex laquelle est citée dans la littérature par la référence « Lagarias, J. C., J. A. Reeds, M. H. Wright, and P. E. Wright, "Convergence Properties of the Nelder-Mead Simplex Method in Low Dimensions." SIAM Journal of Optimization. Vol. 9, Number 1, 1998, pp. 112-147», ou la méthode des moindres carrés, par exemple méthode citée par la référence « Marquardt, D. "An Algorithm for Least-squares Estimation of Nonlinear Parameters." SIAM Journal Applied Mathematics, Vol. 11, 1963, pp. 431-441. », ou encore par une fonction de modélisation d'un logiciel d'analyse de données équivalente à la fonction « Spline » du logiciel Matlab.

On décrit ci-après la variante préférentielle de l'étape de calcul 207 comportant les sous-étapes successives suivantes. Afin de réduire le nombre de paramètres à déterminer pour le calcul d'ajustement paramétrique, le calcul 207 comporte une première sous-étape de translation du signal logarithmique SF mesurée de manière à centrer le point d'inflexion PFL sur les coordonnées d'origine du repère de calcul (0,0). Cette étape présente l'avantage de réduire le nombre à calculer de paramètres de la fonction de modélisation, ici au nombre de deux.

Une deuxième sous-étape consiste ensuite à calculer les paramètres d'ajustement de la fonction de modélisation g, symétrique par rapport au centre du repère d'étude (par rapport aux coordonnées 0,0) et en forme de S, à partir du signal logarithmique SF translaté. La fonction de modélisation g est à titre d'exemple une des fonctions suivantes :

[Math 8]

$$g : x \to a * \tanh(b * x)$$

Ou :

[Math 9]

$$g : x \rightarrow a * \text{arcsinh}(b * x)$$

Ou :

[Math 10]

$$g : x \rightarrow a(sigmf(b * x) - 0,5)$$

Où a et b sont les paramètres à ajuster lors de l'étape de calcul 207, tanh étant une fonction tangente hyperbolique, arcsinh est une fonction Arcsinus hyperbolique et sigmf est une fonction sigmoïde. En figure 3, la fonction de modélisation g illustrée est la fonction tangente hyperbolique.

De plus, selon une variante du procédé, la fonction de modélisation logarithmique MSF est calculée symétriquement par rapport audit point d'inflexion PFL en fonction des valeurs mesurées du signal logarithmique antérieures à l'instant dudit point d'inflexion. En effet, à partir des valeurs du point d'inflexion et de la propriété de symétrie du signal logarithmique SF, il n'est pas nécessaire d'attendre l'équilibre thermique pour estimer l'évolution de la courbe SF postérieurement au point d'inflexion.

D'autres variantes de l'étape de calcul 207 sont envisageables. On peut citer par exemple une méthode de calcul consistant à déterminer lors d'une première sous-étape des points finis du signal logarithmique SF qui sont postérieurs à l'instant t1 du point d'inflexion PFL symétriquement par rapport au point d'inflexion. Ensuite, une deuxième étape de calcul consiste à calculer une fonction de modélisation du signal logarithmique sur des instants allant de 0 à l'infini par interpolation-extrapolation des points mesurés avant t1 et des points calculés symétriquement après t1.

Une autre variante, consiste à mesurer la tension jusqu'à l'équilibre thermodynamique de la batterie et à calculer la fonction de modélisation MSF à partir des échantillons du signal de tension et du signal logarithmique. Les étapes de détection du point d'inflexion 205 et de son enregistrement 206 ne sont pas exécutées lors de l'exécution de cette variante et le procédé passe de l'étape 204 à 207 lorsque l'équilibre thermodynamique est atteint, par exemple après une durée d'une heure.

Ensuite, lors d'une étape 208 du procédé, l'unité de commande calcule un paramètre Vac représentatif de la vitesse d'évolution de la fonction de modélisation MSF du signal logarithmique SF lors de la relaxation. Cette vitesse d'évolution est représentative de la vitesse d'autocatalyse de la batterie lors d'une phase de relaxation. Selon les fonctions de modélisation g décrite précédemment, le paramètre Vac est calculé selon la relation suivante :

[Math 11]

$$Vac = a * b$$

Où a et b sont les paramètres ajustés de l'une des fonctions g mentionnées ci-avant lors de l'étape de calcul 207. En effet, le produit des paramètres ajustés est caractéristique de l'évolution de la vitesse d'autocatalyse et donc de l'état de vieillissement de l'accumulateur électrochimique.

Ensuite, selon une étape 209 du procédé, l'unité de commande estime le paramètre de vieillissement SOH de l'accumulateur électrochimique en lisant la valeur de la cartographie prédéterminée enregistrée en mémoire de l'unité de commande. Cette valeur est lue en fonction du paramètre Vac calculé lors de l'étape 208.

Enfin, selon le procédé à l'étape suivante 210 lorsque l'unité de commande détecte que le courant est non nul, le procédé retourne à l'étape initiale 200 et si le courant est nul, le procédé retourne à l'étape 202.

En figure 4, une cartographie prédéterminée destinée à être enregistrée en mémoire de l'unité de commande est représentée schématiquement. La cartographie met en relation des valeurs prédéterminées du paramètre Vac représentatif de la vitesse d'autocatalyse et des valeurs prédéterminées de l'état de vieillissement de la batterie. La relation entre le paramètre Vac et le paramètre SOH est une fonction linéaire pouvant être exploitée judicieusement par le procédé pour déterminer la valeur de l'état de vieillissement à partir d'une valeur du paramètre Vac.

La cartographie est élaborée en exécutant les étapes 202 à 209 du procédé pour des états de vieillissement connus de la batterie. Ensuite, celle-ci est enregistrée en mémoire d'un module de calcul de l'état de vieillissement d'un système de batterie embarqué.

**Revendications**

1. Procédé de détermination d'un premier paramètre (SOH) représentatif de l'état de vieillissement d'une batterie électrochimique d'un système de batterie, le procédé étant exécuté par une unité de commande du système de batterie et comportant les étapes successives suivantes :

   - la mesure (202) en continu d'un signal de tension, Uacc(t), aux bornes de la batterie en relaxation en fonction du temps écoulé,
   - l'estimation (207) du premier paramètre de d'état de vieillissement dépendant dudit signal de tension mesuré,

   ledit procédé étant **caractérisé en ce qu'**il comporte en outre :

   - le calcul (203) en continu durant la relaxation de la batterie (10) d'un signal logarithmique (SF) de la tension dépendant dudit signal de tension Uacc(t) en fonction de la valeur sous forme logarithmique du temps écoulé à partir du premier instant (t0),
   - une étape de calcul (207) d'une fonction de modélisation (MSF) du signal logarithmique (SF) en fonction des valeurs du signal logarithmique (SF),
   - le calcul (208) d'un deuxième paramètre (Vac) représentatif de la vitesse d'évolution de la fonction de modélisation (MSF) du signal logarithmique (SF) lors de la relaxation, ladite vitesse d'évolution étant représentative de la vitesse d'autocatalyse de la batterie lors d'une phase de relaxation,
   - l'estimation (209) du premier paramètre d'état de vieillissement en fonction du deuxième paramètre (Vac) et d'une cartographie prédéterminée, ladite cartographie étant enregistrée en mémoire de l'unité de commande et fournissant une valeur prédéterminée du premier paramètre d'état de vieillissement en fonction de la valeur du deuxième paramètre (Vac).

2. Procédé selon la revendication 1, **caractérisé en ce que** le calcul (207) de la fonction de modélisation consiste à ajuster les paramètres de la fonction de modélisation (MSF) et le deuxième paramètre (Vac) est calculé en fonction des paramètres ajustés de la fonction de modélisation.

3. Procédé selon la revendication 2, **caractérisé en ce que** la fonction de modélisation (MSF) est une fonction g parmi l'une quelconque des relations suivantes :

[Math 12]

$$g : x \rightarrow a * \tanh(b * x),$$

ou

[Math 13]

$$g : x \rightarrow a * \operatorname{arcsinh}(b * x),$$

ou

[Math 14]

$$g : x \rightarrow a * sigmf(b * x) - 0{,}5,$$

Où a et b sont des paramètres ajustés et le deuxième paramètre Vac est calculé selon la relation suivante :

[Math 15]

$$Vac = a * b$$

4.  Procédé selon l'une quelconque des revendications 1 à 3, **caractérisé en ce qu'**il comporte en outre une étape de détection (205) d'un point d'inflexion du signal logarithmique (SF) de la tension et **en ce que** la fonction de modélisation logarithmique (MSF) est calculée symétriquement par rapport audit point d'inflexion en fonction des valeurs mesurées du signal logarithmique antérieures à l'instant dudit point d'inflexion.

5.  Procédé selon l'une quelconque des revendications 1 à 4, **caractérisé en ce que** la cartographie prédéterminée a été élaborée lors d'une phase de vieillissement d'une batterie électrochimique.

6.  Procédé selon l'une quelconque des revendications 1 à 5, **caractérisé en ce que** la cartographie prédéterminée fournit une pluralité de valeurs d'état de vieillissement prédéterminées en fonction d'une pluralité de valeurs prédéterminées du deuxième paramètre.

7.  Unité de commande d'un système de batterie comportant une batterie électrochimique, **caractérisée en ce qu'**elle comporte en outre une mémoire dans laquelle est enregistrée une cartographie prédéterminée apte à fournir des valeurs prédéterminées d'un premier paramètre d'état de vieillissement de la batterie en fonction de valeurs prédéterminées d'un deuxième paramètre (Vac) représentatif de la vitesse d'autocatalyse de la batterie lors d'une phase de relaxation et des moyens de mettre en œuvre le procédé selon l'une quelconque des revendications 1 à 6.

8.  Véhicule automobile comprenant un système de batterie comportant une unité de commande selon la revendication 7.

**Patentansprüche**

1.  Verfahren zum Bestimmen eines ersten Parameters (SOH), der repräsentativ für den Alterungszustand einer elektrochemischen Batterie eines Batteriesystems ist, wobei das Verfahren von einer Steuereinheit des Batteriesystems ausgeführt wird und die folgenden aufeinanderfolgenden Schritte umfasst:

    - die kontinuierliche Messung (202) eines Spannungssignals Uacc(t) an den Klemmen der Batterie in Relaxation als Funktion der verstrichenen Zeit,
    - die Schätzung (207) des ersten Alterungszustandsparameters abhängig von dem gemessenen Spannungssignal,

    dass es ferner umfasst:

    - kontinuierliches Berechnen (203) während der Entspannung der Batterie (10) eines logarithmischen Signals (SF) der Spannung in Abhängigkeit von dem Spannungssignal Uacc(t) als Funktion des Werts in logarithmischer Form der verstrichenen Zeit von der erste Moment (t0),
    - einen Berechnungsschritt (207) einer Modellierungsfunktion (MSF) des logarithmischen Signals (SF) als Funktion der Werte des logarithmischen Signals (SF),
    - die Berechnung (208) eines zweiten Parameters (Vac), der repräsentativ für die Entwicklungsgeschwindigkeit der Modellfunktion (MSF) des logarithmischen Signals (SF) während der Relaxation ist, wobei die Entwicklungsgeschwindigkeit repräsentativ für die Autokatalysegeschwindigkeit der Batterie während ist eine Entspannungsphase,
    - die Schätzung (209) des ersten Alterungszustandsparameters als Funktion des zweiten Parameters (Vac) und eines vorbestimmten Kennfelds, wobei das Kennfeld im Speicher der Steuereinheit aufgezeichnet ist und einen vorbestimmten Wert des ersten Alterungszustandsparameters liefert als Funktion des Werts des zweiten Parameters (Vac).

2.  Verfahren nach Anspruch 1, **dadurch gekennzeichnet, dass** die Berechnung (207) der Modellierungsfunktion darin besteht, die Parameter der Modellierungsfunktion (MSF) anzupassen, und der zweite Parameter (Vac) gemäß den angepassten Parametern der Funktionsmodellierung berechnet wird.

3.  Verfahren nach Anspruch 2, **dadurch gekennzeichnet, dass** die Modellierungsfunktion (MSF) eine Funktion g aus einer der folgenden Beziehungen ist:

[Mathe 12]

$$g : x \rightarrow a * \tanh(b * x),$$

ou

[Mathe 13]

$$g : x \rightarrow a * \mathrm{arcsinh}(b * x),$$

ou

[Mathe 14]

$$g : x \rightarrow a * sigmf(b * x) - 0{,}5,$$

Wobei a und b angepasste Parameter sind und der zweite Parameter Vac gemäß der folgenden Beziehung berechnet wird:

[Mathe 15]

$$Vac = a * b$$

4.  Verfahren nach einem der Ansprüche 1 bis 3, **dadurch gekennzeichnet, dass** es ferner einen Schritt des Erfassens (205) eines Wendepunkts des logarithmischen Signals (SF) der Spannung umfasst und dass die logarithmische Modellierungsfunktion (MSF) berechnet wird symmetrisch in Bezug auf den Wendepunkt gemäß den gemessenen Werten des logarithmischen Signals vor dem Zeitpunkt des Wendepunkts.

5.  Verfahren nach einem der Ansprüche 1 bis 4, **dadurch gekennzeichnet, dass** das vorgegebene Kennfeld während einer Alterungsphase einer elektrochemischen Batterie erstellt worden ist.

6.  Verfahren nach einem der Ansprüche 1 bis 5, **dadurch gekennzeichnet, dass** die vorgegebene Abbildung mehrere vorgegebene Alterungszustandswerte in Abhängigkeit von mehreren vorgegebenen Werten des zweiten Parameters bereitstellt.

7.  Steuereinheit eines Batteriesystems mit einer elektrochemischen Batterie, **dadurch gekennzeichnet , dass** sie ferner einen Speicher umfasst, in dem ein vorgegebenes Kennfeld aufgezeichnet ist, das in der Lage ist, vorgegebene Werte eines ersten Parameters des Alterungszustands der Batterie als Funktion des vorgegebenen zu liefern Werte eines zweiten Parameters (Vac), der die Autokalyserate der Batterie während einer Entspannungsphase darstellt, und Mittel zur Durchführung des Verfahrens nach einem der Ansprüche 1 bis 6.

8.  Kraftfahrzeug mit einem Batteriesystem mit einer Steuereinheit nach Anspruch 7.


**Claims**

1.  Method for determining a first parameter (SOH) representative of the state of aging of an electrochemical battery of a battery system, the method being executed by a control unit of the battery system and comprising the following successive steps:

    - the continuous measurement (202) of a voltage signal, Uacc(t), at the terminals of the battery in relaxation as a function of the time elapsed,
    - the estimation (207) of the first aging state parameter dependent on said measured voltage signal,

said method being **characterized in that** it further comprises:

- the calculation (203) continuously during the relaxation of the battery (10) of a logarithmic signal (SF) of the voltage depending on said voltage signal Uacc(t) as a function of the value in logarithmic form of the time elapsed from of the first moment (t0),
- a calculation step (207) of a modeling function (MSF) of the logarithmic signal (SF) as a function of the values of the logarithmic signal (SF),
- the calculation (208) of a second parameter (Vac) representative of the speed of evolution of the modeling function (MSF) of the logarithmic signal (SF) during relaxation, said speed of evolution being representative of the speed autocatalysis of the battery during a relaxation phase,
- the estimation (209) of the first aging state parameter as a function of the second parameter (Vac) and of a predetermined map, said map being recorded in the memory of the control unit and providing a predetermined value of the first parameter aging state as a function of the value of the second parameter (Vac).

2. Method according to claim 1, **characterized in that** the calculation (207) of the modeling function consists in adjusting the parameters of the modeling function (MSF) and the second parameter (Vac) is calculated according to the adjusted parameters of the function modeling.

3. Method according to claim 2, **characterized in that** the modeling function (MSF) is a function g from any one of the following relations:

[Math 12]

$$g: x \rightarrow a * \tanh(b * x),$$

ou

[Math 13]

$$g: x \rightarrow a * \operatorname{arcsinh}(b * x),$$

ou

[Math 14]

$$g: x \rightarrow a * sigmf(b * x) - 0,5,$$

Where a and b are adjusted parameters and the second parameter Vac is calculated according to the following relationship:

[Math 15]

$$Vac = a * b$$

4. Method according to any one of claims 1 to 3, **characterized in that** it further comprises a step of detecting (205) a point of inflection of the logarithmic signal (SF) of the voltage and **in that** the function logarithmic modeling (MSF) is calculated symmetrically with respect to said inflection point according to the measured values of the logarithmic signal prior to the instant of said inflection point.

5. Method according to any one of claims 1 to 4, **characterized in that** the predetermined map has been produced during an aging phase of an electrochemical battery.

6. Method according to any one of claims 1 to 5, **characterized in that** the predetermined mapping provides a plurality of predetermined aging state values as a function of a plurality of predetermined values of the second parameter.

7. Control unit of a battery system comprising an electrochemical battery, **characterized in that** it further comprises a memory in which is recorded a predetermined map capable of supplying predetermined values of a first parameter of the state of aging of the battery as a function of predetermined values of a second parameter (Vac) representing the rate of autocatalysis of the battery during a relaxation phase and the means for implementing the method according to any one of Claims 1 to 6.

8. Motor vehicle comprising a battery system comprising a control unit according to claim 7.

[Fig. 1]

[Fig. 2]

[Fig. 3]

[Fig. 4]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2015049300 A1

- WO 2017050944 A1

**Littérature non-brevet citée dans la description**

- **LAGARIAS, J. C. ; J. A. REEDS ; M. H. WRIGHT ; P. E. WRIGHT.** Convergence Properties of the Nelder-Mead Simplex Method in Low Dimensions. *SIAM Journal of Optimization,* 1998, vol. 9 (1), 112-147

- **MARQUARDT, D.** An Algorithm for Least-squares Estimation of Nonlinear Parameters. *SIAM Journal Applied Mathematics,* 1963, vol. 11, 431-441